(19) Europäisches Patentamt
European Patent Office
Office européen des brevets

(11) Publication number: 0 515 850 A2

# (12) EUROPEAN PATENT APPLICATION

(21) Application number: 92107204.7

(22) Date of filing: 28.04.92

(51) Int. Cl.5: H01L 29/73

(30) Priority: 30.04.91 US 693486

(43) Date of publication of application:
02.12.92 Bulletin 92/49

(84) Designated Contracting States:
DE FR GB IT NL

(71) Applicant: TEXAS INSTRUMENTS
INCORPORATED
13500 North Central Expressway
Dallas Texas 75265(US)

(72) Inventor: Bayraktaroglu, Burhan
1100 Edgefield Drive
Plano, Texas 75075(US)

(74) Representative: Schwepfinger, Karl-Heinz,
Dipl.-Ing. et al
Prinz, Leiser, Bunke & Partner Manzingerweg
7
W-8000 München 60(DE)

(54) Lateral collector heterojunction bipolar transistor.

(57) A lateral collector heterojunction bipolar transistor (HBT) comprising a base 20, a base contact 30, an emitter 28 having a wider energy bandgap than the base 20, a collector 14 and a collector contact 18/32 wherein the base contact 30 does not overlay the collector 14 or the collector contact 18/32.

Other devices, systems and methods are also disclosed.

Fig. 1h

EP 0 515 850 A2

## FIELD OF THE INVENTION

This invention generally relates to lateral collector heterojunction bipolar transistors.

## BACKGROUND OF THE INVENTION

Without limiting the scope of the invention, its background is described in connection with phased-array radars, as an example.

Heretofore, in this field, one of the main advantages of the use of heterojunction bipolar transistors (HBTs) for microwave applications is the ability to obtain a large breakdown voltage for the device. For applications such as phased-array radars, where thousands of transmit/receive (T/R) modules are required, high-current conductors represent one of the major system losses. To combat these losses, it is desirable to operate the microwave devices in the T/R modules at a high voltage, thereby lowering device current and consequently system losses.

The breakdown voltage of an HBT device is basically determined by the reverse breakdown voltage of the base-collector p-n junction. It therefore follows that high breakdown voltage devices require thicker collector layers. In a conventional "vertical" HBT, thick collector layers result in tall structures, making it more difficult to isolate devices by mesa etching, trench isolation, implant damage, etc. techniques. For example, 100V HBTs (suitable for L-band and S-band radars, for example) will require 8-10$\mu$m thick structures. This clearly represents a fabrication obstacle.

The vertical nature of HBTs forces the placement of base contact layers directly above collector layers. In order to minimize extrinsic base-collector capacitance, the base contact area is minimized. This leads to increased base contact resistance if the base area is made very small. Also, base contacts directly above collector layers can cause shorting of the base-collector junction when alloyed.

Since the power gain of an HBT is strongly related to both base-collector capacitance, $C_{bc}$, and base resistance, $r_b$, through equation (1), a reduction of both parameters is desirable.

$$f_{max} = \sqrt{\frac{f_t}{8\pi C_{bc} r_b}} \quad (1)$$

Accordingly, improvements which achieve both high breakdown voltage and increased power gain due to lower base-collector capacitance are presently desirable.

## SUMMARY OF THE INVENTION

It is herein recognized that a need exists for a heterojunction bipolar transistor with increased breakdown voltage and lower base-collector capacitance. The present invention is directed towards meeting those needs.

Generally, and in one form of the invention, a lateral collector heterojunction bipolar transistor (HBT) is disclosed comprising a base, a base contact, an emitter having a wider energy bandgap than said base, a collector and a collector contact wherein said base contact does not overlay said collector or said collector contact. Other forms of the invention are also disclosed.

## BRIEF DESCRIPTION OF THE DRAWINGS

The foregoing and further aspects of the invention are illustrated in the accompanying drawings wherein like elements are denoted by like reference designators and in which:

FIG. 1A-H is a cross sectional diagram of the fabrication steps of a first preferred embodiment of the present invention.

FIG. 2 is a cross sectional diagram of a second preferred embodiment of the present invention.

FIG. 3 is a cross sectional diagram of a third preferred embodiment of the present invention.

FIG. 4 is a cross sectional diagram of a fourth preferred embodiment of the present invention.

## DETAILED DESCRIPTION OF PREFERRED EMBODIMENTS

The fabrication steps of a first preferred embodiment of the present invention may be understood with the following description and with reference to Figures 1A-H.

In Figure 1A, a semi-insulating substrate 10, such as GaAs, is provided onto which a suitable mask 12 is established to expose the collector area. The mask 12 can be, for example, patterned photoresist, silicon dioxide, silicon nitride or other materials including metal. A suitable n-type dopant, such as Si, is implanted to a concentration of approximately $2 \times 10^{16}$ cm$^{-3}$ through the mask 12 to form collector region 14. After implantation, the mask 12 is removed.

As shown in Figure 1B, a second mask 16 is established on the substrate 10 and patterned to expose the collector contact area. A suitable n-type dopant, such as Si, is implanted to a concentration of approximately $2 \times 10^{18}$ cm$^{-3}$ through the mask 16 to form collector contact region 18. After implantation, mask 16 is removed.

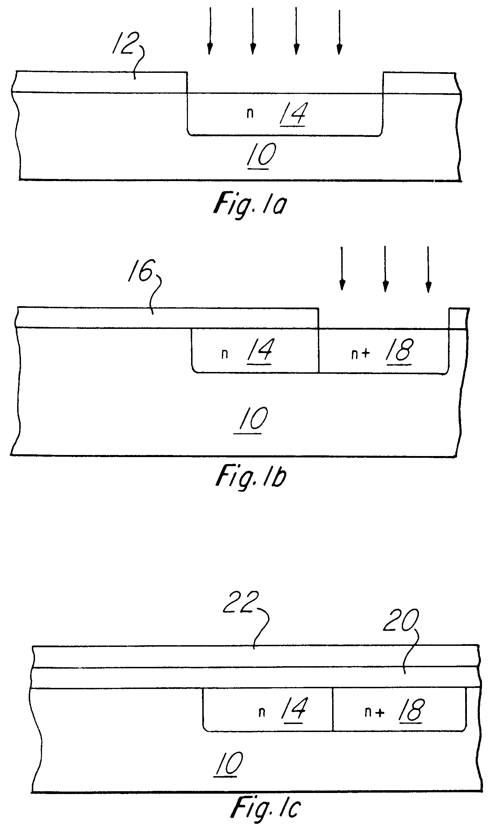

In Figure 1C, semiconductor layer 20, such as GaAs, is grown epitaxially across the entire substrate 10 surface to a thickness of 0.1 $\mu$m, for example, and doped in situ with a suitable p-type dopant, such as Zn or C, to a concentration of approximately $1 \times 10^{19}$ cm$^{-3}$. A second semiconductor layer 22 is next grown epitaxially to thickness of 0.1 $\mu$m, for example, and doped in situ with a suitable n-type dopant, such as Si, to a concentration of approximately $2 \times 10^{17}$ cm$^{-3}$. Epitaxial layer 22 is made from a semiconductor material with a wider energy bandgap than the material of layer 20, such as AlGaAs. A third semiconductor layer 23, such as GaAs, is epitaxially grown over layer 22 to a thickness of 0.15 $\mu$m, for example, and doped with a suitable n-type dopant, such as Si, to a concentration of approximately $3 \times 10^{18}$ cm$^{-3}$. Layer 23 will later form an interface between the AlGaAs emitter and the emitter contact metal. An implantation mask (not shown) is then established, through which O$_2$, B, H or other suitable ions are implanted to convert areas outside of the active regions into semi-insulating regions 21. The mask is then removed. This defines the device active area.

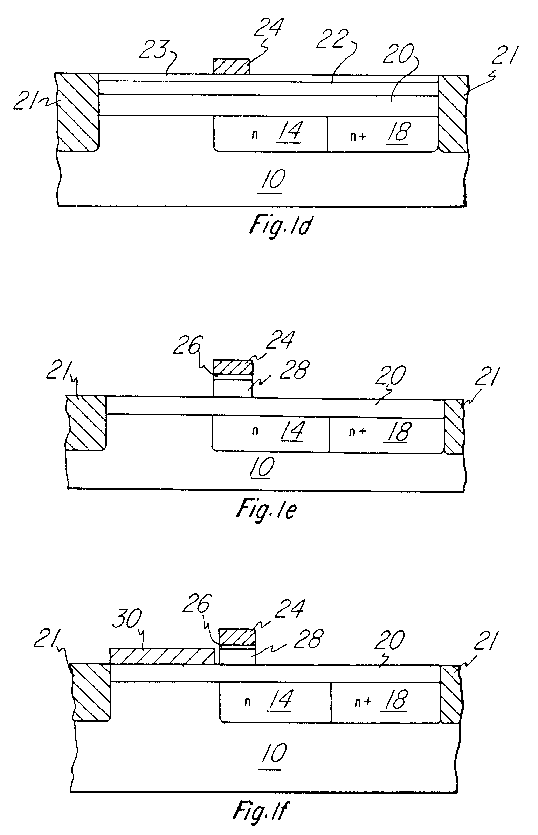

With reference to Figure 1D, a layer of photoresist (not shown) is spun onto the wafer and patterned to expose the emitter contact area. Suitable emitter metals, such as AuGe/Ni/Au are evaporated in sequence at thicknesses of 500, 140 and 4000 Angstroms, respectively, onto the photoresist and exposed areas. The photoresist is then removed, which lifts off the metal except that portion 24 that defines the HBT emitter contact metal. The contact metal 24 is then alloyed at 430°C for 1 minute to complete the ohmic contact formation.

As shown in Figure 1E, emitter contact metal 24 is used as a mask to etch epilayers 22 and 23 down to layer 20 to form the HBT emitter contact 26 and emitter 28. A reactive ion etch (RIE) is used (BCl$_3$, CCl$_3$, CCl$_2$F$_2$, etc.) for anisotropic etching, followed by a short wet chemical etch to remove layers damaged by the RIE.

In Figure 1F, another layer of photoresist (not shown) is spun onto the wafer and patterned to expose the base contact area. Suitable base metals such as Ti/Pt/Au in thicknesses of 500, 250 and 2000 Angstroms, respectively, are sequentially evaporated onto the photoresist and exposed areas. The photoresist is then removed, which lifts off the metal except those portions 30 that define the base contact.

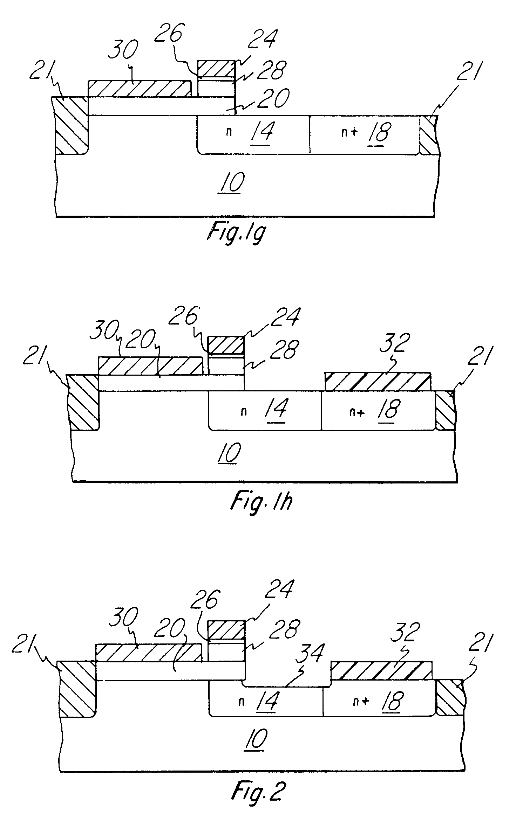

As shown in Figure 1G, another layer of photoresist (not shown) is spun onto the wafer and patterned to protect the previously formed emitter and base regions. RIE is then used to etch base layer 20 down to the substrate 10 surface in those areas not protected by the mask. To minimize the collector capitance for superior microwave operation, the protective photoresist mask edge can be placed partially over the emitter finger rather than completely covering it. During the GaAs etch process, the emittor metal 24 will then also serve as a mask.

Figure 1H illustrates the formation of the collector contact of the HBT. Another layer of photoresist (not shown) is spun onto the wafer and patterned to define the collector contact area. AuGe/Ni/Au metals are evaporated in sequence at thicknesses of 500, 140 and 4000 Angstroms, respectively, onto the photoresist and exposed areas. The photoresist is then removed, which lifts off the metal except that portion 32 that defines the HBT collector contact. The contact 32 is then alloyed at 430°C for 1 minute to complete the ohmic contact formation.

In a second preferred embodiment of the present invention, the device of Figure 1 may be further modified to provide improved base-collector breakdown voltage. As shown in Figure 2, the thickness of the collector region 14 can be further modified by etching away the area 34 with RIE between the emitter and collector metals 24 and 32, respectively. All other areas of the device are protected by a suitable mask layer (not shown), such as photoresist or silicon nitride, for example, during this etch. It is desirable to achieve a collector region 14 thickness and doping level which enables complete depletion of charges in the collector under all collector bias conditions, resulting in improved base-collector breakdown voltage.

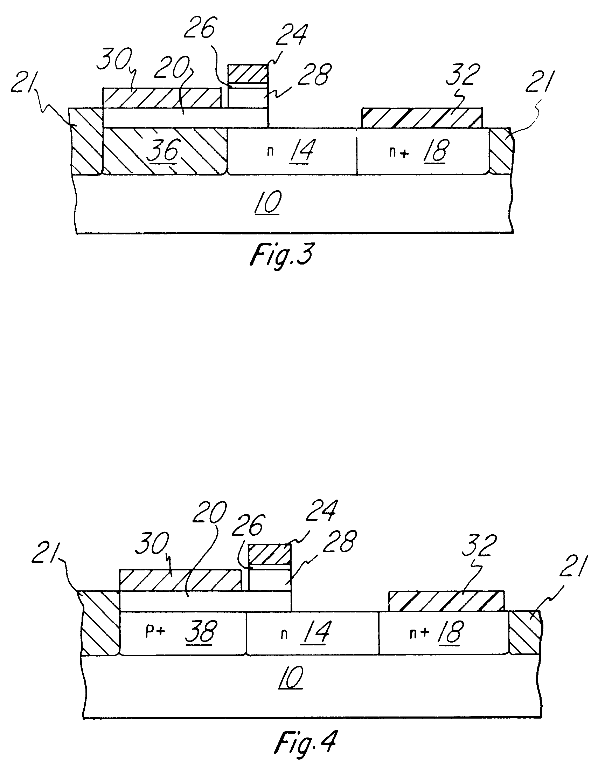

A third preferred embodiment of the present invention is shown in Figure 3. Prior to the epitaxial deposition of the base layer 20, an isolation implant is performed in the region 36 of the substrate 10 beneath the base finger of the device. This ion implantation may be performed with boron or oxygen, for example. The conversion of the region 36 into semi-insulating material further reduces the base-collector capacitance by inhibiting charge carrier flow betwwen the base and the collector.

A fourth preferred embodiment of the present invention is shown in Figure 4. In this instance, the region 38 of the substrate 10 beneath the base finger of the device is doped to be p+ material. The inclusion of the region 38 provides reduction in the base-collector capacitance as in the third preferred embodiment, but also provides a much thicker region on which to make the base contact 30.

From the foregoing, it will be readily apparent to those skilled in the art that the device of the present invention has several advantages over the prior art. First, the breakdown voltage can be determined by the distance the collector contact region 18 is placed from the edge of the emitter area. Also, the surface layer of the collector region 14 can be modified by recess etching or implantation to further control the breakdown voltage. The base contact 30 is large, which lowers base resistance, yet it does not have a collector under it, thereby avoiding excessive base-collector capacitance which is then normal result of a large base contact. Additionally, although current flow in the device is vertical, the base-collector (external) capacitance is lateral, and therefore much smaller than in the case of a standard vertical HBT. Lastly, if the base contact 30 alloys through the base layer 20, it will not short out the base-collector junction.

A few preferred embodiments have been described in detail hereinabove. It is to be understood that the scope of the invention also comprehends embodiments different from those described, yet within the scope of the claims.

For example, a graded semiconductor layer may be inserted between layers 22 and 23 to provide a smooth bandgap transition between the AlGaAs emitter layer 22 and the GaAs emitter contact layer 23.

Words of inclusion are to be interpreted as nonexhaustive in considering the scope of the invention.

Internal and external connections can be ohmic, capacitive, direct or indirect, via intervening circuits or otherwise. Implementation is contemplated in discrete components or fully integrated circuits in silicon, gallium arsenide, or other electronic materials families.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

## Claims

1. A lateral collector hetorojunction bipolar transistor (HBT) comprising a base, a base contact, an emitter having a wider energy bandgap than said base, a collector and a collector contact wherein said base contact does not overlay said collector or said collector contact.

2. A lateral collector heterojunction bipolar transistor (HBT) comprising:

a semiconductor substrate having a first surface;

a collector region of a first conductivity type in said substrate at said first surface;

a collector contact region of said first conductivity type in said substrate at said first surface, said collector contact region adjoining said collector region;

a base layer of a second conductivity type disposed on said first surface, a portion of said base layer disposed over a portion of said collector region;

an emitter layer of said first conductivity type disposed on the portion of said base layer overlying said collector region, said emitter layer having a wider energy bandgap than said base layer;

a conductive base contact disposed on said base layer, said base contact not overlying said collector region or said collector contact region;

a conductive emitter contact disposed on said emitter layer; and

a conductive collector contact disposed on said collector contact region.

3. The HBT of either of Claims 1 or 2 wherein said collector is an implanted region in a substrate and said base and said emitter are epitaxial layers grown on said substrate.

4. The HBT of either of Claims 2 or 3 wherein a portion of said substrate under said base is doped relatively heavily, said portion having the same conductivity-type as said base.

5. The HBT of either of Claims 2 or 3 wherein said emitter is AlGaAs and said base and said collector are GaAs.

6. The HBT of either of Claims 2 or 3 wherein a surface of said collector region is recessed between said base and said collector contact in order to further control base-to-collector breakdown voltage.

7. The HBT of either of Claims 2 or 3 wherein a portion of said substrate under said base layer is semi-insulating as a result of ion-implantation.

8. The HBT of Claim 2 further comprising an emitter contact layer of said first conductivity type disposed between said emitter layer and said conductive emitter contact.

9. The HBT of Claim 2 wherein said first conductivity type is n-type and said second conductivity type is p-type.

10. A method of forming a lateral collector heterojunction bipolar transistor (HBT) comprising the steps of forming a base, forming a base contact, forming an emitter having a wider energy bandgap than said base, forming a collector, and forming a collector contact wherein said base contact does not overlay said collector or said collector contact.

11. The method of Claim 10 wherein said emitter is formed of AlGaAs and said base and said collector are formed of GaAs.

12. The method of either of Claims 10 or 11 wherein said forming a collector step comprises ion implantation in a substrate and said forming a base and said forming an emitter steps comprises epitaxial deposition on said substrate.

13. A method of forming a lateral collector heterojunction bipolar transistor (HBT) comprising the steps of:

providing a semiconductor substrate having a first surface;

implanting a collector region of a first conductivity type in said substrate at said first surface;

implanting a collector contact region of said first conductivity type in said substrate at said first surface, said collector contact region adjoining said collector region;

growing a base layer of a second conductivity type on said first surface, a portion of said base layer disposed over a portion of said collector region;

growing an emitter layer of said first conductivity type on the portion of said base layer overlying said collector region, said emitter layer having a wider energy bandgap than said base layer;

forming a conductive base contact on said base layer, said base contact not overlying said collector region or said collector contact region;

forming a conductive emitter contact on said emitter layer; and

forming a conductive collector contact on said collector contact region.

14. The method of Claim 13 further comprising the step of growing an emitter contact layer of said first conductivity type between said emitter layer and said conductive emitter contact.

15. The method of either of Claims 13 and 14 comprising the further steps of selecting said substrate to be GaAs, growing said base layer with GaAs, and growing said emitter layer with AlGaAs.

16. The method of any of Claims 13-15 comprising the further step of selecting said first conductivity type to be n-type and said second conductivity type to be p-type.

17. The method of either of Claims 12 or 13 further comprising the step of recessing a surface of said collector between said base and said collector contact in order to further control base-to-collector breakdown voltage.

18. The method of either of Claims 12 or 13 further comprising the step of converting a portion of said substrate under said base layer to semi-insulating by ion-implantation.

19. The method of either of Claims 12 or 13 further comprising the step of doping a portion of said substrate under said base layer relatively heavily, said doping being of the same conductivity type as said base layer.

Fig. 1a

Fig. 1b

Fig. 1c

*24*

*23* *22* *20* *21*

*21*

| n *14* | n+ *18* |

*10*

Fig.1d

*26* *24*

*21* *28*

*20* *21*

| n *14* | n+ *18* |

*10*

Fig.1e

*30* *26* *24*

*21* *28*

*20* *21*

| n *14* | n+ *18* |

*10*

Fig.1f

Fig.1g

Fig.1h

Fig.2

Fig.3

Fig.4